# EUROPEAN PATENT APPLICATION

(11) **EP 4 425 584 A1**
(43) Date of publication of application: **04.09.2024**
(21) Application number: 22887265.1
(22) Date of filing: 02.06.2022
(51) Int. Cl.: H01L 33/36, H01L 25/075

(54) **DISPLAY DEVICE USING SEMICONDUCTOR LIGHT-EMITTING ELEMENT**

(30) Priority: 26.10.2021 KR 20210143156
(71) Applicant: LG Electronics Inc., Yeongdeungpo-gu Seoul 07336 (KR)
(72) Inventor: CHANG, Myungwhun, Seoul 06772 (KR); KIM, Yanghyun, Seoul 06772 (KR); RYOO, Seungho, Seoul 06772 (KR); WON, Jonghwa, Seoul 06772 (KR); KIM, Donghyun, Seoul 06772 (KR); SHIN, Jonggon, Seoul 06772 (KR); PAIK, Kimun, Seoul 06772 (KR)
(74) Representative: Schornack, Oliver
(86) International application number: PCT/KR2022/007821
(87) International publication number: WO 2023/075059

(57) **Abstract**

The present disclosure is applicable to a display device-related technical field and relates to, for example, a display device using a micro light-emitting diode (LED). The present disclosure as such comprises: a wiring board on which a plurality of unit pixel regions are defined; a wiring electrode arranged on the wiring board, the wiring electrode comprising a first wiring electrode and a second wiring electrode; and a light-emitting element that forms a sub-pixel by being installed to be electrically connected to the first wiring electrode and the second wiring electrode in each of the unit pixel regions, wherein the light-emitting element may be configured to comprise: a first light-emitting element located in a first pixel region and installed in a first arrangement; and a second light-emitting element located in a second pixel region neighboring the first pixel region and installed in a second arrangement that is symmetrical to the first arrangement.

## Description

### TECHNICAL FIELD

The present disclosure is applicable to a display device-related technical field, and relates to, for example, a display device using a micro light emitting diode (LED).

### BACKGROUND

Recently, display devices with excellent characteristics such as thinness and flexibility are being developed in a field of display technology. Currently, commercially available major displays are represented by a liquid crystal display (LCD) and an organic light emitting diode (OLED).

In one example, a light emitting diode (LED), as a well-known semiconductor light emitting device that converts current into light, has been used as a light source for an image displayed in electronic devices including an information and communication device along with a GaP:N-based green LED, starting with commercialization of a red LED using a GaAsP compound semiconductor in 1962.

Recently, such light emitting diode (LED) has been gradually miniaturized and manufactured as a micrometer-sized LED to be used for pixels or flat lighting of the display device.

Sapphire, which is used as a substrate on which a gallium nitride-based semiconductor is grown, has a tilted crystal surface. For example, a R-plane has a crystal surface tilted along a m-axis. The ordinary sapphire may have the R-plane as a growth plane. Because the R-plane has a surface tilted with respect to a hexagonal prism crystal shape, the sapphire substrate and the gallium nitride-based semiconductor grown on the crystal surface of the sapphire substrate may have such a tilt angle.

In addition, such a tilt angle may also be formed as a light emitting device is formed as the gallium nitride-based semiconductor on the sapphire substrate and then is cut in a direction of the crystal surface of the sapphire substrate.

Accordingly, when the light emitting device is mounted on a wiring substrate in a general arrangement and emits light, an individual sub-pixel may be constructed in a state having an asymmetrical light distribution with respect to a direction for connecting two electrode pads with respect to one light emitting device and the individual sub-pixels may constitute the display device.

As such, when the display device is formed with the individual sub-pixels with the asymmetrical light distribution, a problem in that, when viewing the display device from the outside, a color of a display appears differently depending on a viewing direction may occur.

In addition, an unintended parasitic capacitance may occur due to an electric field formed by a difference in polarity between a signal electrode/a common electrode of the light emitting device.

Accordingly, even when the electric field is dissipated, discharge of the parasitic capacitance may not be normally performed, and thus a situation in which an adjacent light emitting device is unintentionally turned on may occur.

The corresponding effect may be accumulated by the total number of light emitting devices used in the display device, and finally, a ghost phenomenon may appear in a unit of a display product.

Therefore, there is a demand for a method capable of solving such problem.

### DISCLOSURE

### TECHNICAL PROBLEM

The present disclosure is to provide a display device using a semiconductor light emitting device that may cancel the biased light distributions of the light emitting devices caused by the crystallinity of the light emitting devices.

In addition, the present disclosure is to provide a display device using a semiconductor light emitting device that may solve a problem in that, when viewing the display device from the outside, a color of a display appears differently depending on a viewing direction.

In addition, according to an embodiment of the present disclosure, the present disclosure is to provide a display device using a semiconductor light emitting device that may visually reinforce an area with weak color when viewing the display from one side to correct a color difference of the display perceived on left and right sides.

### TECHNICAL SOLUTION

According to a first aspect of the present disclosure, a display device using a light emitting device includes a wiring substrate with a plurality of unit pixel regions defined thereon, a pair of wiring electrodes arranged in a unit pixel region on the wiring substrate, a pair of electrode pads connected to the air of wiring electrodes, respectively, and a light emitting device electrically connected to and installed on the pair of electrode pads to define a sub pixel, wherein the light emitting device has a tilt angle with a side surface inclined to one side and the pair of electrode pads have different thicknesses.

According to an exemplary embodiment, a thickness difference of the electrode pads is to compensate for the tilt angle.

According to an exemplary embodiment, the tilt angle is an angle with respect to a perpendicular direction of a main plane of the wiring substrate.

According to an exemplary embodiment, a thickness difference of the electrode pads is disposed to decrease the tilt angle.

According to an exemplary embodiment, the electrode pad includes a first electrode pad and a second electrode pad, and at least one of the first electrode pad or the second electrode pad includes a thickness compensator.

According to an exemplary embodiment, the thickness compensator is to compensate for the tilt angle.

According to an exemplary embodiment, wherein a thickness difference between the first pad and the second pad corresponds to the tilt angle of the light emitting device.

According to an exemplary embodiment, the tilt angle is due to crystallinity of a semiconductor material of the light emitting device.

According to an exemplary embodiment, the light emitting device has a cross section or side surface of a parallelogram.

According to an exemplary embodiment, the light emitting device has asymmetric light distribution according to the tilt angle, and a thickness difference of the electrode pad corrects the asymmetric light distribution.

According to a second aspect of the present disclosure, a display device using a light emitting device includes a wiring substrate with a plurality of unit pixel regions defined thereon, a first wiring electrode and a second wiring electrode arranged in a unit pixel region on the wiring substrate, a first electrode pad and a second electrode pad connected to the first wiring electrode and the second wiring electrode, respectively, and a light emitting device electrically connected to and installed on the first electrode pad and the second electrode pad to define a sub pixel, wherein the light emitting device has a tilt angle with a side surface inclined to one side and the first pad and the second pad have thicknesses corresponding to the tilt angle of the light emitting device.

According to an exemplary embodiment, a thickness difference of the first pad and the second pad is to compensate for the tilt angle.

According to an exemplary embodiment, a thickness difference of the first pad and the second pad is disposed to decrease the tilt angle.

According to an exemplary embodiment, the light emitting device has asymmetric light distribution according to the tilt angle, and a thickness difference of the first pad and the second pad corrects the asymmetric light distribution.

### ADVANTAGEOUS EFFECTS

According to one embodiment of the present disclosure, the following effects are obtained.

First, according to one embodiment of the present disclosure, the biased light distributions of the light emitting devices resulting from the crystallinity of the light emitting devices may be cancelled with each other. That is, the asymmetrical light distributions of the light emitting devices may be canceled.

Accordingly, the problem in that, when viewing the display device from the outside, the color of the display appears differently depending on the viewing direction may be solved.

In addition, according to one embodiment of the present disclosure, the area with the weak color may be visually reinforced when viewing the display from one direction to correct the color difference between the left and right sides of the display. Therefore, the effect of enhancing the color viewing angle in the final product stage of the display device may be obtained.

Furthermore, according to another embodiment of the present disclosure, there are additional technical effects not mentioned here. A person skilled in the art may understand this via the entire meaning of the present document and drawings.

### BRIEF DESCRIPTION OF THE DRAWINGS

FIG. 1 is a schematic diagram of a display device using a semiconductor light emitting device according to an embodiment of the present disclosure.
FIG. 2 is a schematic diagram showing an example of a state in which a light emitting device is installed on an electrode pad of a display device using a semiconductor light emitting device according to an embodiment of the present disclosure.
FIG. 3 is a schematic diagram illustrating another example of a state in which a light emitting device is installed on an electrode pad of a display device using a semiconductor light emitting device according to an embodiment of the present disclosure.
FIG. 4 is a schematic diagram illustrating a subpixel arrangement of a display device using a semiconductor light emitting device according to an embodiment of the present disclosure.
FIG. 5 is a schematic diagram illustrating an effect of a sub-pixel arrangement of a display device using a semiconductor light emitting device according to an embodiment of the present disclosure.
FIG. 6 is a side picture showing a separate light emitting device of a display device using a semiconductor light emitting device according to an embodiment of the present disclosure.
FIG. 7 is a schematic diagram illustrating a tilt angle of a separate light emitting device of a display device using a semiconductor light emitting device according to an embodiment of the present disclosure.
FIG. 8 schematically shows a sapphire crystal face and crystal orientation.
FIG. 9 are pictures showing side pictures light emitting devices of a display device using a semiconductor light emitting device according to an embodiment of the present disclosure.
FIG. 10 are schematic diagrams illustrating tilt angles of light emitting devices of a display device using a semiconductor light emitting device according to an embodiment of the present disclosure.
FIG. 11 is a graph showing an example of light distribution of a light emitting device used in a display device using a semiconductor light emitting device according to an embodiment of present disclosure.
FIG. 12 is a graph showing another example of light distribution of a light emitting device used in a display device using a semiconductor light emitting device according to an embodiment of the present disclosure.
FIG. 13 is a schematic diagram for explaining tilt angle compensation of a light emitting device of a display device using a semiconductor light emitting device according to an embodiment of present disclosure.
FIG. 14 shows a uniform light distribution in which biased light distributions shown in FIG. 11 or 12 cancel each other out.

### DETAILED DESCRIPTION

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions.

In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

A semiconductor light emitting device mentioned herein is a concept including an LED, a micro LED, and the like, and is able to be used interchangeably with those.

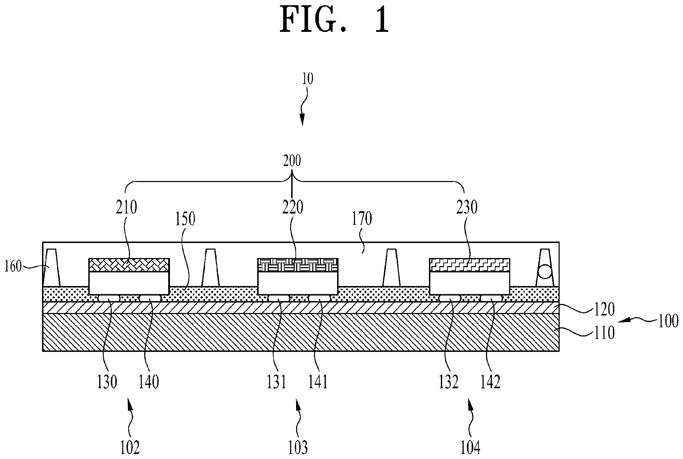

FIG. 1 is a schematic diagram of a display device using a semiconductor light emitting device according to an embodiment of the present disclosure.

Referring to FIG. 1, in a display device 10, an individual unit pixel area 101 may be partitioned on a wiring substrate 100, and multiple light emitting devices 200: 210, 220, and 230 may be installed within such unit pixel area 101.

In this regard, the individual light emitting devices 210, 220, and 230 installed in the unit pixel area 101 may substantially correspond to sub-pixels, respectively. For example, three sub-pixels may be gathered to constitute one pixel. In FIG. 1, the three light emitting devices 210, 220, and 230 may correspond to red, green, and blue light emitting devices, respectively.

Each of the light emitting devices 210, 220, and 230 may be electrically connected to a pair of electrode pads 130 and 140/131 and 141/132 and 142. In this case, as an example, the electrode pads 130, 131, and 132 (hereinafter, referred to as first electrode pads) arranged on one side in FIG. 1 may be connected to first wiring electrodes (signal electrodes or data electrodes) 121, 122, and 123, respectively.

In addition, the electrode pads 140, 141, and 142 arranged on the other side (hereinafter, referred to as second electrode pads) may be connected to a second wiring electrode (a common electrode or a scan electrode) 124. However, an opposite case thereof is also possible. In FIG. 1, the signal electrodes 121, 122, and 123 and the common electrode 124 are omitted due to an arrangement of electrodes and pads.

In one example, in some cases, the first electrode pads 130, 131, and 132 may respectively correspond to the signal electrodes 121, 122, and 123, and the second electrode pads 140, 141, and 142 may correspond to the common electrode 124.

Hereinafter, reference numerals of the electrode pads and the wiring electrodes are used interchangeably for description. That is, the electrode pads and the wire electrodes may be described using the same reference numerals.

As such, unit sub-pixels may be defined at points where the first wiring electrodes 121, 122, and 123 and the second wiring electrode 124 intersect each other.

In one example, when the first wiring electrodes 121, 122, and 123 are the signal electrodes (or the data electrodes), such first wiring electrodes 121, 122, and 123 or the first electrode pads 130, 131, and 132 may be connected to a TFT layer 120 on which a thin film transistor (TFT) is disposed. Accordingly, each of the light emitting devices 210, 220, and 230 may be driven by switching driving resulted from such TFT layer 120.

In FIG. 1, the TFT layer 120 is briefly shown as a single layer, but the TFT layer 120 may include multiple TFT areas capable of performing the switching operation. For example, each TFT area may include a gate electrode, a source electrode, a drain electrode, an insulating layer disposed therebetween, a via electrode that may be connected to the first wiring electrodes 121, 122, and 123 or the first electrode pads 130, 131, and 132, and the like. A detailed description of this is omitted. Each of such TFT areas may be connected to each of the light emitting devices 210, 220, and 230.

The multiple light emitting devices 200; 210, 220, and 230 may be installed to be electrically connected onto the wiring electrodes 121, 122, 123, and 124 to form individual sub-pixels.

As mentioned above, such light emitting devices 200 may include the red light emitting device 210, the green light emitting device 220, and the blue light emitting device 230, and such three light emitting devices 210, 220, and 230 may form the individual sub-pixels and be repeatedly positioned on the wiring substrate 100. Such light emitting devices 210, 220, and 230 may include at least one of an organic light emitting device or an inorganic light emitting device. For example, the light emitting devices 210, 220, and 230 may be the inorganic semiconductor light emitting devices (light emitting diodes; LEDs).

Such semiconductor light emitting device (LED) 200 may have a size of a micrometer (*µ*m) unit. The micrometer (*µ*m) size may mean that a width of at least one surface of the light emitting device 200 has a size of several to hundreds of micrometers (*µ*m).

The TFT layer 120 may be positioned on a substrate 110, and an insulating layer 150 may be coated on the TFT layer 120. Such insulating layer 150 may be coated on a connection portion between the wiring electrodes 121, 122, 123, and 124, the electrode pads 130, 131, 132/140, 141, and 142, and the light emitting devices 210, 220, and 230.

For example, the individual light emitting devices 210, 220, and 230 may be separated from each other by a partition wall 160. In addition, a cover layer 170 may be positioned on the light emitting devices 210, 220, and 230 and the partition wall 160.

As described above, the light emitting devices 210, 220, and 230 may form the individual sub-pixels and be repeatedly positioned on the wiring substrate 100. For example, each pixel area 101 may be repeatedly disposed on the wiring substrate 100.

In this regard, the pixel areas 101 may be repeatedly positioned along one line of the data electrodes (the first wiring electrodes) 121, 122, and 123 or line of the scan electrode (the second wiring electrode) 124 in a longitudinal direction. For example, in FIG. 1, the red light emitting device 210, the green light emitting device 220, and the blue light emitting device 230 may be repeatedly positioned along a left and right direction. For example, a red light emitting device of an adjacent pixel area may be positioned on a right side of the blue light emitting device 230.

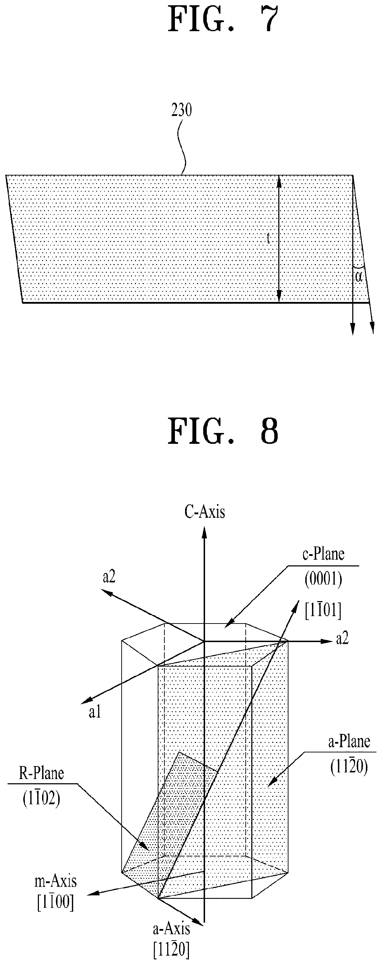

In one example, another data electrode (first wiring electrode) line or scan electrode (second wiring electrode) line adjacent to one data electrode (first wiring electrode) line or scan electrode (second wiring electrode) line in a parallel manner may be located (see FIG. 8). In this regard, a pixel area 102 (see FIG. 8) having the same arrangement of the light emitting devices 210, 220, and 230 as the pixel area 101 may be located on the adjacent data electrode (first wiring electrode) line or scan electrode (second wiring electrode) line.

In this case, light emitting devices having the same color may be located adjacent to each other in adjacent pixel areas. For example, the red light emitting device 210, the green light emitting device 220, and the blue light emitting device 230 may be repeatedly positioned along the data electrode (first wiring electrode) line or the scan electrode (second wiring electrode) line, but light emitting devices having the same color may be repeatedly positioned in a direction perpendicular to such data electrode (first wiring electrode) line or the scan electrode (second wiring electrode) line.

In this regard, according to one embodiment of the present disclosure, two adjacent light emitting devices may have different arrangements. For example, referring to FIG. 1, the red light emitting device 210 and the green light emitting device 220 adjacent to the red light emitting device 210 may have different arrangements.

For example, in the red light emitting device 210, a first-type electrode, for example, an N-type electrode, may be positioned on the first wiring electrode 130, and in the green light emitting device 220, a second-type electrode, for example, a P-type electrode, may be positioned on the first wiring electrode 131. Such different arrangements may also be made on the green light emitting device 220 and the blue light emitting device 230.

That is, the red light emitting device 210 and the green light emitting device 220 adjacent to such red light emitting device 210 may have symmetrical arrangements with respect to electrode positions of the respective light emitting devices 210 and 220.

In one example, a light emitting device (e.g., the red light emitting device 210) located in one pixel area 101 and a light emitting device (e.g., the red light emitting device 210) located in the adjacent pixel area 102 may have symmetrical arrangements with respect to the electrode positions as described above.

In other words, on the wiring substrate 100, a first light emitting device 210 located in the first pixel area 101 and installed in a first arrangement, and a second light emitting device 210 located in the second pixel area 102 adjacent to such first pixel area 101 and installed in a second arrangement symmetric with respect to the first arrangement may be positioned.

With the first and second arrangements of the light emitting devices 210 as described above, a parasitic capacitance generated from a difference in electrical polarity between the first light emitting device and the second light emitting device may be reduced.

In addition, with the first arrangement and the second arrangement of the light emitting devices 210 as described above, an electric field generated from the difference in the electric polarity between the first light emitting device and the second light emitting device may be canceled.

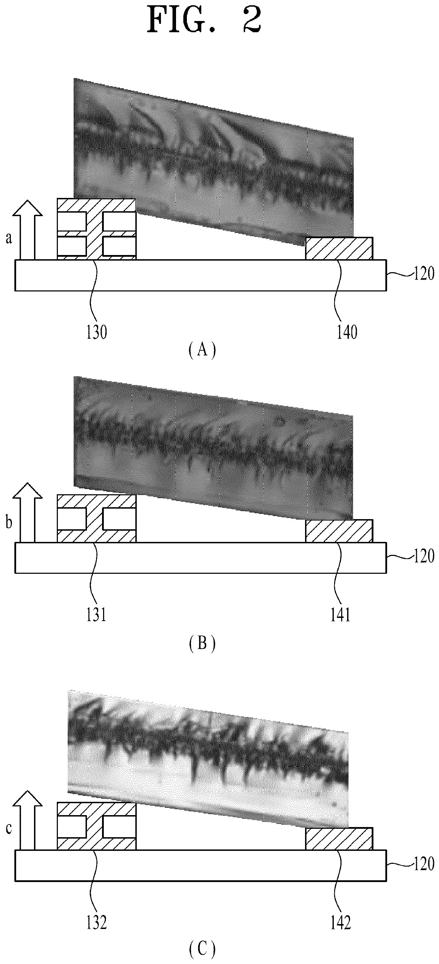

FIG. 2 is a schematic diagram showing an example of a state in which a light emitting device is installed on an electrode pad of a display device using a semiconductor light emitting device according to an embodiment of the present disclosure.

(A) in FIG. 2 shows a state in which a red light emitting device 210 is electrically connected to and installed on electrode pads 130 and 140, and (B) in FIG. 2 shows a state in which a green light emitting device 220 electrically connected to and installed on electrode pads 131 and 141. (C) in FIG. 2 shows a state in which a blue light emitting device 230 is electrically connected to and installed on electrode pads 132 and 142.

(A) in FIG. 2 shows a state in which the red light emitting device 210 is electrically connected to and installed on a pair of electrode pads 130 and 140 having different thicknesses located on a thin film transistor (TFT) layer 120. Here, the two electrode pads 130 and 140 are shown as being located on the TFT layer 120, but the present disclosure is not limited thereto, and the two electrode pads 130 and 140 may be located in a region defining a subpixel location on a wiring substrate 100.

As shown in (A) in FIG. 2, a light emitting device 210 may have a tilt angle at which a side surface is inclined toward one side. The tilt angle of the light emitting device 210 may be a result of material characteristics of a material constituting the light emitting device 210. This will be described later in detail.

The pair of electrode pads 130 and 140 may include a first electrode pad 130 and a second electrode pad 140. At this time, the first electrode pad 130 and the second electrode pad 140 may have different thicknesses. Accordingly, an installation height of the light emitting device 210 may be different from one side to the other side.

(A) in FIG. 2 shows that a thickness 'a' of the first electrode pad 130 is larger than the thickness of the second electrode pad 140.

The difference in thickness between the first electrode pad 130 and the second electrode pad 140 may be to compensate for a tilt angle of a light emitting device 310.

Here, the tilt angle may be an angle of a main plane of the wiring substrate 100 (a main plane of the TFT layer 120 in (A) in FIG. 2) with respect to a vertical direction. At this time, the thickness difference between the first electrode pad 130 and the second electrode pad 140 may be set in a direction in which the tilt angle decreases.

In other words, the light emitting device 210 may have an inclined tilt angle, and the tilt angle may be compensated for by the thickness difference between the first electrode pad 130 and the second electrode pad 140. That is, the inclined tilt angle of the light emitting device 210 may be vertical due to the thickness difference between the first electrode pad 130 and the second electrode pad 140.

Light distribution of the light emitting device 210 may be asymmetrical with respect to a light emitting surface of the light emitting device 210 due to the inclined tilt angle of the light emitting device 210, but the asymmetric light distribution may be symmetrically compensated for by the thickness difference between the first electrode pad 130 and the second electrode pad 140.

(B) in FIG. 2 shows a state in which the green light emitting device 220 is electrically connected to and installed on a pair of electrode pads 131 and 141 having different thicknesses located on the TFT layer 120. Here, the two electrode pads 131 and 141 are shown as being located on the TFT layer 120, but the present disclosure is not limited thereto, and the two electrode pads 131 and 141 may be located in a region defining a subpixel position on the wiring substrate 100.

The pair of electrode pads 131 and 141 may include a first electrode pad 131 and a second electrode pad 141. In this case, the first electrode pad 131 and the second electrode pad 141 may have different thicknesses. Accordingly, an installation height of the green light emitting device 220 may be different from one side to the other side.

(B) in FIG. 2 shows that a thickness 'b' of the first electrode pad 131 is larger than the thickness of the second electrode pad 141.

The difference in thickness between the first electrode pad 131 and the second electrode pad 141 may be to compensate for a tilt angle of the green light emitting device 220.

Light distribution of the light emitting device 220 may be asymmetrical with respect to a light emitting surface of the light emitting device 220 due to an inclined tilt angle of the light emitting device 220, but the asymmetric light distribution may be symmetrically compensated for by the thickness difference between the first electrode pad 131 and the second electrode pad 141.

(C) in FIG. 2 shows a state in which the blue light emitting device 230 is electrically connected to and installed on a pair of electrode pads 132 and 142 having different thicknesses located on the TFT layer 120. Here, the two electrode pads 132 and 142 are shown as being located on the TFT layer 120, but the present disclosure is not limited thereto, and the two electrode pads 132 and 142 may be located in a region defining a subpixel position on the wiring substrate 100.

The pair of electrode pads 132 and 142 may include a first electrode pad 132 and a second electrode pad 142. In this case, the first electrode pad 132 and the second electrode pad 142 may have different thicknesses. Accordingly, an installation height of the blue light emitting device 230 may be different from one side to the other side.

(C) in FIG. 2 shows that a thickness 'c' of the first electrode pad 132 is larger than the thickness of the second electrode pad 142.

A difference in thickness between the first electrode pad 132 and the second electrode pad 142 may be to compensate for a tilt angle of the blue light emitting device 230.

Light distribution of the light emitting device 230 may be asymmetrical with respect to a light emitting surface of the light emitting device 230 due to the inclined tilt angle of the light emitting device 230, but the asymmetric light distribution may be symmetrically compensated for by the thickness difference between the first electrode pad 132 and the second electrode pad 142.

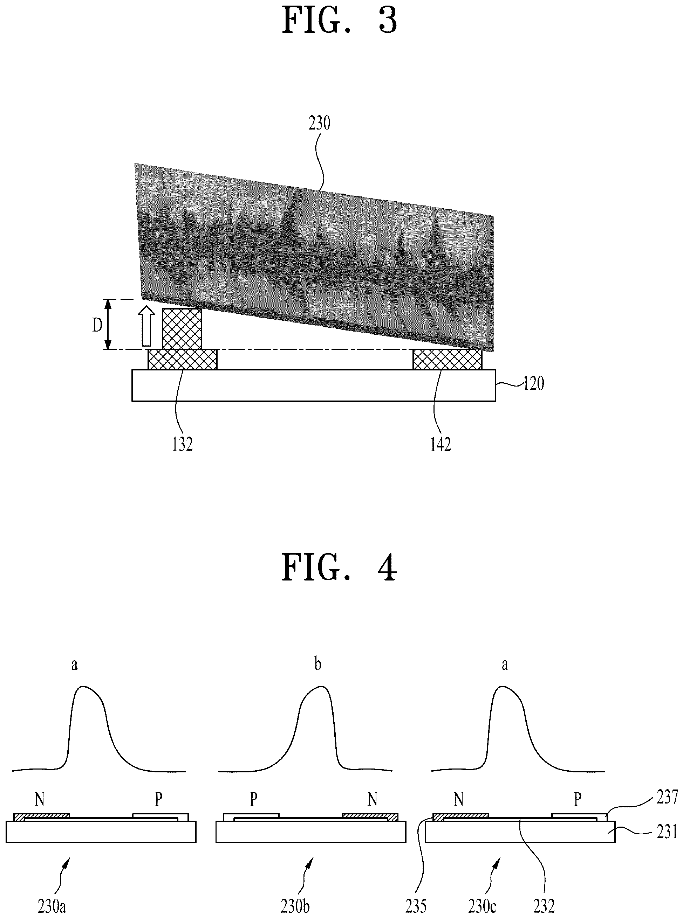

FIG. 3 is a schematic diagram illustrating another example of a state in which a light emitting device is installed on an electrode pad of a display device using a semiconductor light emitting device according to an embodiment of the present disclosure.

FIG. 3 shows a state in which the blue light emitting device 230 is electrically connected to and installed on a pair of electrode pads 132 and 142 having different thicknesses located on the TFT layer 120.

FIG. 3 shows that the thickness of the first electrode pad 132 is larger than the thickness of the second electrode pad 142 by D. At this time, a part that causes a thickness difference in the first electrode pad 132 may be referred to as a thickness compensator D.

The thickness difference D between the first electrode pad 132 and the second electrode pad 142, that is, the thickness compensator D may be to compensate for a tilt angle of the blue light emitting device 230.

Due to the inclined tilt angle of the light emitting device 230, light distribution of the light emitting device 230 may be asymmetric with respect to a light emitting surface of the light emitting device 230, but the asymmetric light distribution may be symmetrically compensated for by the thickness difference between the first electrode pad 132 and the second electrode pad 142.

In this way, the tilt angle of the blue light emitting device 230 may be compensated for by configuring the thickness compensator D after forming the first electrode pad 132 and the second electrode pad 142 to have the same thickness.

Although the thickness compensator D has been exemplarily described for the blue light emitting device 230, this may be equally applied to the red light emitting device 210 and the green light emitting device 220 needless to say.

FIG. 4 is a schematic diagram illustrating a subpixel arrangement of a display device using a semiconductor light emitting device according to an embodiment of the present disclosure.

FIG. 4 shows a state in which a first light emitting device 230a and a second light emitting device 230b adjacent to each other are positioned in different arrangements, first arrangement and second arrangement. In addition, the second light emitting device 230b and the third light emitting device 230c may also be positioned with different arrangements.

For example, the first light emitting device 230a and the third light emitting device 230c may be positioned in a first arrangement, and the second light emitting device 230b positioned between the first light emitting device 230a and the third light emitting device 230c may be located with a second arrangement.

In this case, the first light emitting device 230a, the second light emitting device 230b, and the third light emitting device 230c may all be light emitting devices emitting the same color light. For example, the first light emitting device 230a, the second light emitting device 230b, and the third light emitting device 230c may all be blue light emitting devices.

Here, the first arrangement may be an arrangement in which an N type electrode 235 is located on a left side and a P type electrode 237 is located on a right side in FIG. 4. In the light emitting devices 230a, 230b, and 230c, a semiconductor layer 232 is located on the substrate 231, and a first type electrode in contact with the semiconductor layer 232, for example, the N type electrode 235 and a second type electrode, for example, the P type electrode 237 may be located.

That is, the light emitting devices 230a, 230b, and 230c may include the substrate 231, the semiconductor layer 232, a first type electrode 235, and a second type electrode 237. In this case, the light emitting devices 230a, 230b, and 230c may have a different arrangement with respect to a direction in which the first type electrode 235 and the second type electrode 237 are connected.

Referring to FIG. 4, the light emitting devices 230a, 230b, and 230c may have light distributions a and b that are asymmetric with respect to a direction in which the first type electrode 235 and the second type electrode 237 are connected. For example, the first light emitting device 230a and the third light emitting device 230c may have light distribution 'a' biased to a left side. This may correspond to the first arrangement. The second light emitting device 230b positioned between the first light emitting device 230a and the third light emitting device 230c may have light distribution 'b' biased to a right side. This may correspond to the second arrangement.

This may be a result of a material characteristic of at least one of the substrate 231 or the semiconductor layer 232. For example, this phenomenon may occur because a crystal structure of at least one of the substrate 231 or the semiconductor layer 232 has an inclined shape. This will be described later in detail.

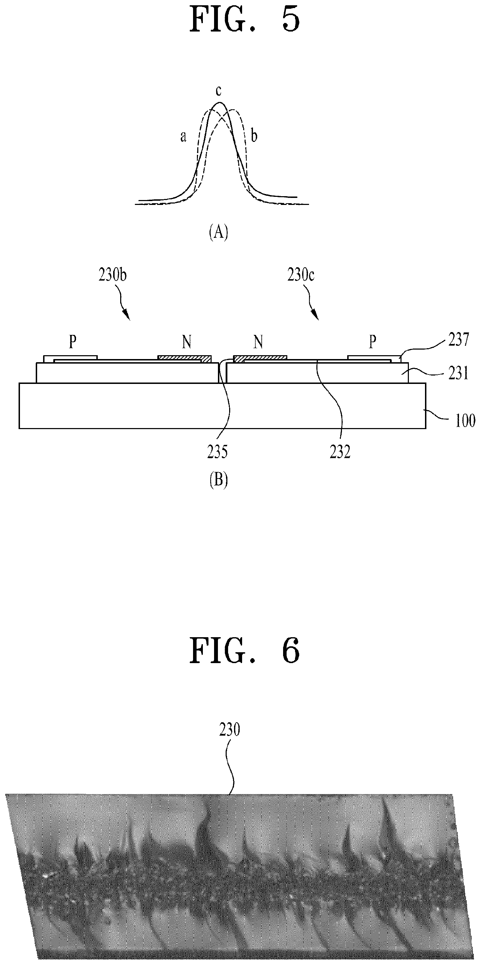

FIG. 5 is a schematic diagram illustrating an effect of a sub-pixel arrangement of a display device using a semiconductor light emitting device according to an embodiment of the present disclosure.

Referring to FIG. 5, the light emitting devices 230b and 230c that are installed on the wiring substrate 100 and form the sub-pixels may be disposed.

In this regard, referring to (B) in FIG. 5 on a lower side, as described with reference to FIG. 1 above, the wiring substrate 100 may include the wiring electrodes 123 and 124 including the first wiring electrode 123 and the second wiring electrode 124 arranged on the wiring substrate 100, and each of the light emitting devices 230b and 230c may be installed to be electrically connected to the first wiring electrode 123 and the second wiring electrode 124 in each unit pixel area. That is, the sub-pixel arrangement in FIG. 5 may correspond to the case of the blue light emitting device 230 in FIG. 1.

In this regard, referring to (A) and (B) in FIG. 5 together, the light emitting devices 230b and 230c may include a first light emitting device 230b located in the first pixel area and installed in the first arrangement, and a second light emitting device 230c located in the second pixel area adjacent to the first pixel area and installed in the second arrangement symmetrical to the first arrangement.

Each of the first light emitting device 230b and the second light emitting device 230c may include the substrate 231, the semiconductor layer 232, the first-type electrode 235, and the second-type electrode 237. In this regard, the first light emitting device 230b and the second light emitting device 230c may have different arrangements with respect to the direction for connecting the first-type electrode 235 and the second-type electrode 237 to each other.

Accordingly, the light distribution a biased to one side by the first arrangement and the light distribution b biased to the other side by the second arrangement may be merged together to form light distribution 'c' that is not biased and faces the center. That is, the asymmetrical light distributions may be canceled by the first arrangement of the first light emitting device 230b and the second arrangement of the second light emitting device 230c as described above.

In this regard, as described above, the first light emitting device 230b and the second light emitting device 230c may be light emitting devices that emit light of the same color located in the adjacent pixel areas, for example, the blue light emitting devices.

When a positive voltage is applied to a light emitting diode (LED) with a PN junction structure, charges and holes recombine with each other in an area where a P-area and an N-area meet each other to emit light. In this regard, a portion where the greatest amount of light is emitted is not a center of the area where the P-area and the N-area meet each other, but is biased. Therefore, when a display is manufactured with such an LED, a color of the display may appear differently depending on a direction for viewing the display.

However, as described above, when the first arrangement of the first light emitting device 230b and the second arrangement of the second light emitting device 230c are symmetrical with each other, a color difference of the display perceived on left and right sides when viewing the display from one side may be compensated for by visually reinforcing an area with weak color. Therefore, an effect of enhancing a color viewing angle in a final product stage of the display device may be obtained.

In addition, an electric field formed by a difference in polarity between the light emitting devices 230b and 230c may be removed by the symmetrical arrangements of the first light emitting device 230b and the second light emitting device 230c, so that a parasitic capacitance may be prevented from being generated. In addition, the ghost phenomenon that may occur due to such parasitic capacitance may be improved.

FIG. 6 is a side picture showing a separate light emitting device of a display device using a semiconductor light emitting device according to an embodiment of the present disclosure. FIG. 7 is a schematic diagram illustrating a tilt angle of a separate light emitting device of a display device using a semiconductor light emitting device according to an embodiment of the present disclosure.

FIG. 6 is an enlarged picture showing a side of the blue light emitting device 230. FIG. 6 shows a sapphire substrate forming most of the thickness of the blue light emitting device 230. As shown in FIG. 7, a tilt angle α of the blue light emitting device 230 may be approximately 10 degrees. For example, a thickness `t' of the blue light emitting device 230 may be 80 µm.

However, a gallium nitride semiconductor layer located on a sapphire substrate may have the same or similar tilt angle. In some cases, the sapphire substrate is removed after the light emitting device is manufactured. In this case, a gallium nitride-based semiconductor layer, not the substrate, of the light emitting device may have the above tilt angle.

FIG. 8 schematically shows a sapphire crystal face and crystal orientation. Sapphire may be used as a growth substrate for a light emitting device formed of a gallium nitride-based semiconductor.

As shown in the drawing, sapphire has an inclined crystal plane. For example, an R-plane has a crystal plane inclined in an m-axis. Ordinary sapphire may have an R-plane as a growth plane. Referring to FIG. 8, since the R-plane has an inclined plane with respect to a hexagonal prism crystal shape, a sapphire substrate and gallium nitride-based semiconductor grown on the crystal plane of the sapphire substrate may have such an inclined tilt angle.

Such a tilt angle may be formed due to cutting in a direction of the crystal plane of the sapphire substrate after the light emitting device is formed with a gallium nitride-based semiconductor on the sapphire substrate.

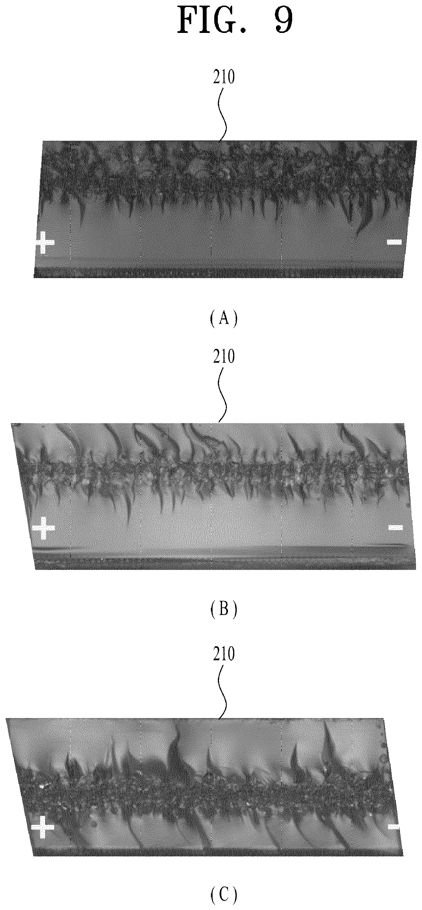

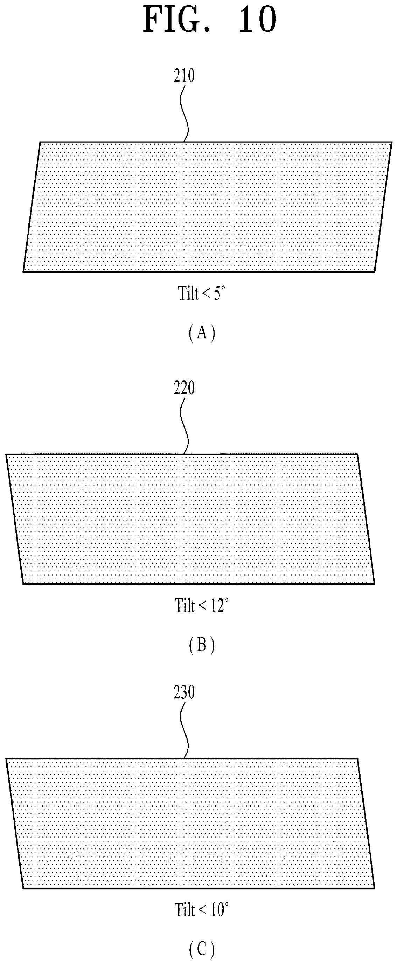

FIG. 9 are pictures showing side pictures light emitting devices of a display device using a semiconductor light emitting device according to an embodiment of the present disclosure. FIG. 10 are schematic diagrams illustrating tilt angles of light emitting devices of a display device using a semiconductor light emitting device according to an embodiment of the present disclosure.

Referring to FIGS. 9 and 10, light emitting devices that may be used in display may have various tilt angles. For example, the light emitting device shown in (A) in FIG. 9 and (A) in FIG. 10 may have a tilt angle of 5 degrees or less in one direction.

In addition, the light emitting device shown in (B) in FIG. 9 and (B) in FIG. 10 has a tilt angle of 12 degrees or less in an opposite direction to the tilt angle of the light emitting device shown in in (A) in FIG. 9 and (A) in FIG. 10.

The light emitting device shown in (C) in FIG. 9 and (C) in FIG. 10 has a tilt angle of 10 degrees or less in the same direction as the tilt angle of the light emitting device shown in (B) in FIG. 9 and (B) in FIG. 10.

In this way, the light emitting device has a parallelogram structure in which a side end surface is biased to one side, and as described above, the light emitting device may have a light emitting pattern that is uneven and inclined to one side with respect to a direction perpendicular to the surface.

As such, with regard to the light emitting devices 210, 220, and 230 having a tilt angle, the tilt angle may be compensated for by the configuration of electrode pads 130, 131, 132/140, 141, and 142 having different thicknesses as shown in FIGS. 2 and 3.

Accordingly, the light emitting patterns of the light emitting devices 210, 220, and 230 that are biased according to the tilt angle may be compensated.

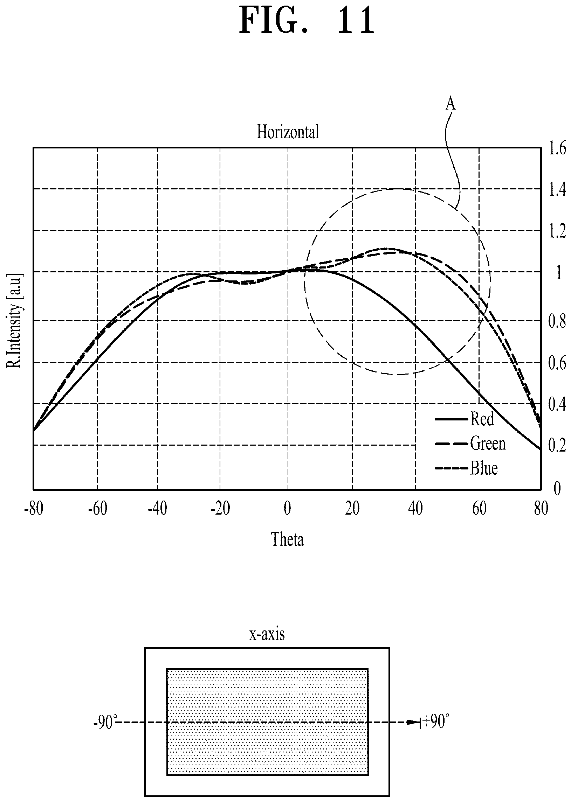

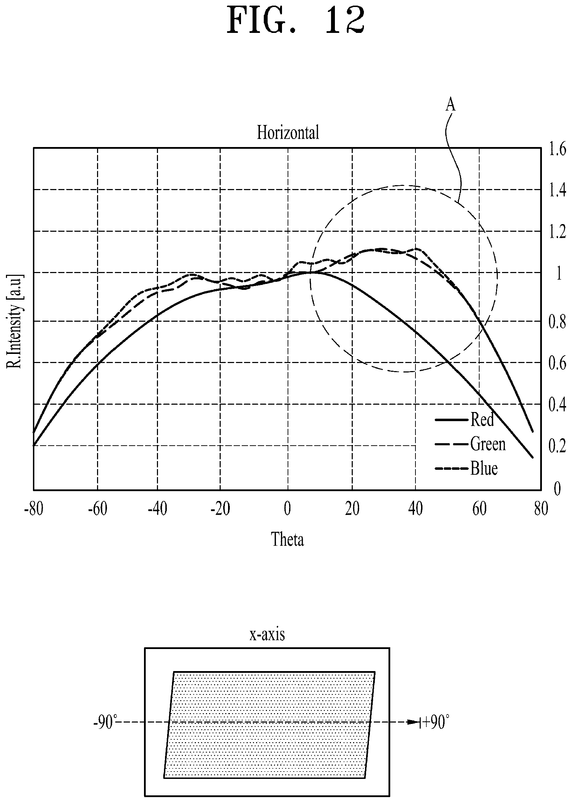

FIG. 11 is a graph showing an example of light distribution of a light emitting device used in a display device using a semiconductor light emitting device according to an embodiment of present disclosure. FIG. 12 is a graph showing another example of light distribution of a light emitting device used in a display device using a semiconductor light emitting device according to an embodiment of the present disclosure.

FIGS. 11 and 12 both show the intensity of light measured along a long axis (x-axis) of a light emitting device. That is, the center of the long axis corresponds to 0 degree, and luminous intensity is expressed on left and right sides.

FIG. 11 shows light distributions for red, green, and blue light emitting devices. As seen the drawing, asymmetric light distribution is shown to the left and right of the center.

Referring to FIG. 11, light distribution having a greater luminous intensity is shown in a right portion A with respect to 0 degrees. Similarly, referring to FIG. 12, light distribution having a greater luminous intensity is shown in a right portion B with respect to 0 degree.

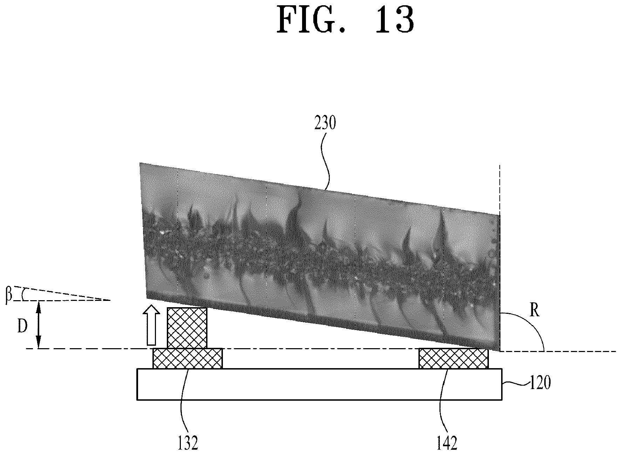

FIG. 13 is a schematic diagram for explaining tilt angle compensation of a light emitting device of a display device using a semiconductor light emitting device according to an embodiment of present disclosure.

FIG. 13 may be substantially the same as FIG. 3 described above. That is, FIG. 13 shows a state in which the blue light emitting device 230 is electrically connected to and installed on a pair of electrode pads 132 and 142 having different thicknesses located on the TFT layer 120.

FIG. 13 shows that the thickness of the first electrode pad 132 is larger than the thickness of the second electrode pad 142 by D. At this time, a portion that causes a thickness difference in the first electrode pad 132 may be referred to as the thickness compensator D.

By this thickness compensator D, a predetermined angle β may be defined between an angle of a light emitting surface of the light emitting device 230 or an installation surface parallel to the light emitting surface (a surface in contact with the electrode pads 132 and 142) and a main plane of the wiring substrate 100 (or a main plane of the TFT layer 120).

In other words, this predetermined angle β may be the same as the tilt angle of the light emitting device 230. The thickness compensator D may compensate for the tilt angle of the light emitting device 230 by making the light emitting surface of the light emitting device 230 form the predetermined angle β with respect to the main plane of the wiring substrate 100.

By compensating for the tilt angle of the light emitting device 230, a side angle R of the light emitting device 230 with respect to the main plane of the wiring substrate 100 may form a substantially right angle. However, the side angle R of the light emitting device 230 with respect to the main plane of the wiring substrate 100 may be an angle close to a right angle even if the side angle R is not an exact right angle. Accordingly, light distribution pattern of the light emitting device 230 may be formed symmetrically by compensating for the tilt angle of the light emitting device 230.

The blue light emitting device 230 has been exemplarily described for an operation due to a thickness difference between the first electrode pad 132 and the second electrode pad 142 and an operation of the thickness compensator D, but this may be applied to the red light emitting device 210 and the green light emitting device 220 in the same way.

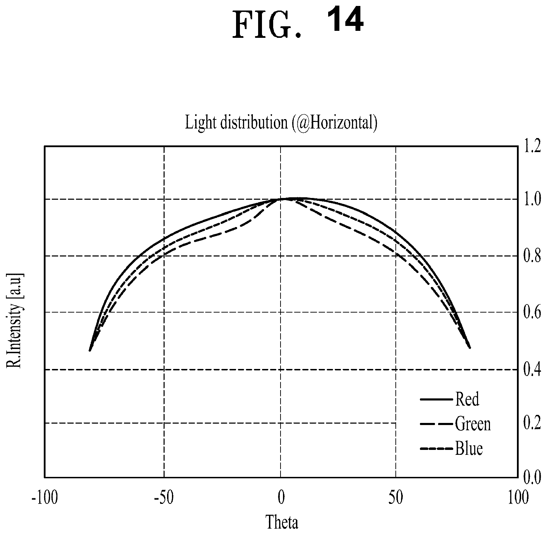

FIG. 14 shows uniform light distribution in which biased light distributions shown in FIG. 11 or 12 cancel each other out. That is, as seen from FIG. 14, the light distribution as shown in FIG. 11 is uniformed according to arrangement of the light emitting devices described with reference to FIGS. 2 to 4.

As such, by setting the thickness difference between the first electrode pads 130, 131, and 132 and the second electrode pads 140, 141, and 142 or the configuration of the thickness compensator D, biased light distributions a and b due to the crystal structure of the light emitting devices 210, 220, and 230 may be corrected to achieve uniform light distribution.

Accordingly, a problem in which color is different depending on a viewing direction when the display device is viewed from the outside may be overcome.

The above description is merely illustrative of the technical idea of the present disclosure. Those of ordinary skill in the art to which the present disclosure pertains will be able to make various modifications and variations without departing from the essential characteristics of the present disclosure.

Therefore, embodiments disclosed in the present disclosure are not intended to limit the technical idea of the present disclosure, but to describe, and the scope of the technical idea of the present disclosure is not limited by such embodiments.

The scope of protection of the present disclosure should be interpreted by the claims below, and all technical ideas within the scope equivalent thereto should be construed as being included in the scope of the present disclosure.

### INDUSTRIAL APPLICABILITY

According to present disclosure, a display device using a semiconductor light emitting device such as a micro light emitting diode (LED) may be provided.

## Claims

1. A display device using a light emitting device, comprising:
a wiring substrate with a plurality of unit pixel regions defined thereon;
a pair of wiring electrodes arranged in a unit pixel region on the wiring substrate;
a pair of electrode pads connected to the air of wiring electrodes, respectively; and
a light emitting device electrically connected to and installed on the pair of electrode pads to define a sub pixel,
wherein the light emitting device has a tilt angle with a side surface inclined to one side and the pair of electrode pads have different thicknesses.

2. The display device using the light emitting device of claim 1, wherein a thickness difference of the electrode pads is configured to compensate for the tilt angle.

3. The display device using the light emitting device of claim 1, wherein the tilt angle is an angle with respect to a perpendicular direction of a main plane of the wiring substrate.

4. The display device using the light emitting device of claim 1, wherein a thickness difference of the electrode pads is disposed to decrease the tilt angle.

5. The display device using the light emitting device of claim 1, wherein the electrode pad includes a first electrode pad and a second electrode pad, and at least one of the first electrode pad or the second electrode pad includes a thickness compensator.

6. The display device using the light emitting device of claim 5, wherein the thickness compensator is to compensate for the tilt angle.

7. The display device using the light emitting device of claim 5, wherein a thickness difference between the first pad and the second pad corresponds to the tilt angle of the light emitting device.

8. The display device using the light emitting device of claim 1, wherein the tilt angle is due to crystallinity of a semiconductor material of the light emitting device.

9. The display device using the light emitting device of claim 1, wherein the light emitting device has a cross section or side surface of a parallelogram.

10. The display device using the light emitting device of claim 1, wherein the light emitting device has asymmetric light distribution according to the tilt angle, and a thickness difference of the electrode pad corrects the asymmetric light distribution.

11. A display device using a light emitting device, comprising:
a wiring substrate with a plurality of unit pixel regions defined thereon;
a first wiring electrode and a second wiring electrode arranged in a unit pixel region on the wiring substrate;
a first electrode pad and a second electrode pad connected to the first wiring electrode and the second wiring electrode, respectively; and
a light emitting device electrically connected to and installed on the first electrode pad and the second electrode pad to define a sub pixel,
wherein the light emitting device has a tilt angle with a side surface inclined to one side and the first pad and the second pad have thicknesses corresponding to the tilt angle of the light emitting device.

12. The display device using the light emitting device of claim 11, wherein a thickness difference of the first pad and the second pad is to compensate for the tilt angle.

13. The display device using the light emitting device of claim 11, wherein the tilt angle is an angle with respect to a perpendicular direction of a main plane of the wiring substrate.

14. The display device using the light emitting device of claim 13, wherein a thickness difference of the first pad and the second pad is disposed to decrease the tilt angle.

15. The display device using the light emitting device of claim 11, wherein at least one of the first electrode pad or the second electrode pad includes a thickness compensator.

16. The display device using the light emitting device of claim 15, wherein the thickness compensator is to compensate for the tilt angle.

17. The display device using the light emitting device of claim 11, wherein the tilt angle is due to crystallinity of a semiconductor material of the light emitting device.

18. The display device using the light emitting device of claim 11, wherein the light emitting device has asymmetric light distribution according to the tilt angle, and a thickness difference of the first pad and the second pad corrects the asymmetric light distribution.
